# EUROPEAN PATENT APPLICATION

(11) **EP 3 846 180 A1**
(43) Date of publication of application: **07.07.2021**
(21) Application number: 19853687.2
(22) Date of filing: 30.08.2019
(51) Int. Cl.: H01B 7/08, H01B 7/02, H01B 13/00, H01B 13/06, H01B 3/30

(54) **METHOD OF MANUFACTURING TRANSMISSION LINE USING NANOSTRUCTURE MATERIAL FORMED BY ELECTRO-SPINNING**

(30) Priority: 31.08.2018 KR 20180103923
(71) Applicant: Sensorview Incorporated, Gyeonggi-do 13493 (KR)
(72) Inventor: KIM, Byoung Nam, Bucheon-si Gyeonggi-do 14549 (KR); KANG, Kyoung Il, Suwon-si Gyeonggi-do 16694 (KR)
(74) Representative: Brann AB
(86) International application number: PCT/KR2019/011112
(87) International publication number: WO 2020/046031

(57) **Abstract**

Disclosed is a method of manufacturing a transmission line using a nanostructured material. The method includes locating a first insulating layer above a first nanoflon layer including nanoflon, forming a first conductive layer above the first insulating layer, forming a first pattern, which transmits and receives a signal, by etching the first conductive layer, and locating a first ground layer below the first nanoflon layer. Here, the nanoflon is a nanostructured material formed by electrospinning a liquid resin at a high voltage.

## Description

### CROSS-REFERENCE TO RELATED APPLICATION

This application claims priority to and the benefit of Korean Patent Application No. 2018-0103923, filed on August 31, 2018, the disclosure of which is incorporated herein by reference in its entirety.

### BACKGROUND

### 1. Field of the Invention

The present invention relates to a transmission line, and more particularly, to a method of manufacturing a transmission line using a nanostructured material formed by electrospinning a liquid resin at a high voltage.

### 2. Discussion of Related Art

In order to transmit or treat a superhigh frequency signal at a low loss, a low-loss and high performance transmission line is necessary. Generally, losses at a transmission line are roughly divided into a conductor loss caused by a metal and a dielectric loss caused by a dielectric. Particularly, a loss caused by dielectric increases when permittivity of a dielectric is higher, and a power loss increases when resistance is greater.

Accordingly, in order to manufacture a low-loss and high performance transmission line for transmitting a superhigh frequency signal, it is necessary to use a material having low permittivity and a small loss tangent. Particularly, in order to efficiently transmit signals having frequencies in bands of 3.5 GHz and 28 GHz used in 5G mobile communication network, the significance of a transmission line and an antenna which have a low loss even in a superhigh frequency band increases more and more.

### SUMMARY OF THE INVENTION

The present invention is directed to providing a method of manufacturing a transmission line using a nanostructured material formed by electrospinning, which has low permittivity and is capable of reducing a loss tangent value at the low permittivity to reduce a loss at a transmission line caused by a dielectric to satisfy necessity for a low-loss and high performance transmission line.

According to an aspect of the present invention, there is provided a method of manufacturing a transmission line using a nanostructured material formed through electrospinning. The method includes locating a first insulating layer above a first nanoflon layer including nanoflon, forming a first conductive layer above the first insulating layer, forming a first pattern, which transmits and receives a signal, by etching the first conductive layer, and locating a first ground layer below the first nanoflon layer. Here, the nanoflon is a nanostructured material formed by electrospinning a liquid resin at a high voltage.

According to another aspect of the present invention, there is provided a method of manufacturing a transmission line using a nanostructured material formed through electrospinning. The method includes forming a first conductive layer on a first insulating layer, locating the first insulating layer above a first nanoflon layer including nanoflon, forming a first pattern, which transmits and receives a signal, by etching the first conductive layer, and locating a first ground layer below the first nanoflon layer. Here, the nanoflon is a nanostructured material formed by electrospinning a liquid resin at a high voltage.

The forming of the first pattern may include forming a ground line and a signal line by etching the first conductive layer.

The method may further include locating a second nanoflon layer on the first pattern formed on the first insulating layer and the first insulating layer exposed by the etching and locating a second ground layer on the second nanoflon layer.

The method may further include locating a second nanoflon layer on the first pattern formed on the first insulating layer and the first insulating layer exposed by the etching, locating a second ground layer on the second nanoflon layer, locating a third nanoflon layer on the second ground layer, locating a second insulating layer on the third nanoflon layer, forming a second conductive layer on the second insulating layer, and forming a second pattern, which transmits and receives a signal, by etching the second conductive layer.

The forming of the second pattern may include forming a transmission-signal line and a ground terminal by etching the second conductive layer.

The method may further include locating a fourth nanoflon layer on the second pattern formed on the second insulating layer and the second insulating layer exposed by the etching and locating a third ground layer on the fourth nanoflon layer.

The locating may be performed through adhesion using an adhesive tape or an adhesive or using thermal adhesion in which heat is applied to an adhesive tape.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 illustrates an example of an apparatus which manufactures nanoflon through electrospinning;
FIG. 2 illustrates an example of a stripline transmission line;
FIG. 3 is a cross-sectional view illustrating a first embodiment of a transmission line manufactured using a transmission line manufacturing method according to the present invention;
FIG. 4 is a cross-sectional view of the transmission line which illustrates adhesion to a first nanoflon layer according to the transmission line manufacturing method according to the present invention;
FIG. 5 is a cross-sectional view illustrating a second embodiment of the transmission line manufactured using the transmission line manufacturing method according to the present invention;
FIG. 6 is a cross-sectional view illustrating a third embodiment of the transmission line manufactured using the transmission line manufacturing method according to the present invention;
FIG. 7 is a cross-sectional view of the transmission line which illustrates adhesion to a second nanoflon layer 610 according to the transmission line manufacturing method according to the present invention;
FIG. 8 is a cross-sectional view illustrating a fourth embodiment of the transmission line manufactured using the transmission line manufacturing method according to the present invention;
FIG. 9 is a cross-sectional view illustrating a fifth embodiment of the transmission line manufactured using the transmission line manufacturing method according to the present invention;
FIG. 10 is a cross-sectional view illustrating a sixth embodiment of the transmission line manufactured using the transmission line manufacturing method according to the present invention;
FIG. 11 illustrates a first embodiment of a method of manufacturing a transmission line using a nanostructured material formed by electrospinning according to the present invention;
FIG. 12 illustrates a second embodiment of the method of manufacturing the transmission line using the nanostructured material formed by electrospinning according to the present invention;
FIG. 13 illustrates a third embodiment of the method of manufacturing the transmission line using the nanostructured material formed by electrospinning according to the present invention;
FIG. 14 illustrates a fourth embodiment of the method of manufacturing the transmission line using the nanostructured material formed by electrospinning according to the present invention;
FIG. 15 illustrates a fifth embodiment of the method of manufacturing the transmission line using the nanostructured material formed by electrospinning according to the present invention;
FIG. 16 illustrates a sixth embodiment of the method of manufacturing the transmission line using the nanostructured material formed by electrospinning according to the present invention;
FIGS. 17a, 17b, and 17c illustrate a seventh embodiment of the method of manufacturing the transmission line using the nanostructured material formed by electrospinning according to the present invention;
FIGS. 18a, 18b, 18c, and 18d illustrate an eighth embodiment of the method of manufacturing the transmission line using the nanostructured material formed by electrospinning according to the present invention;
FIGS. 19a and 19b illustrate a ninth embodiment of the method of manufacturing the transmission line using the nanostructured material formed by electrospinning according to the present invention; and
FIGS. 20a and 20b illustrate a tenth embodiment of the method of manufacturing the transmission line using the nanostructured material formed by electrospinning according to the present invention.

### DETAILED DESCRIPTION OF EXEMPLARY EMBODIMENTS

Hereinafter, exemplary embodiments of the present invention will be described in detail with reference to the attached drawings. Since embodiments disclosed in the specification and components shown in the drawings are merely exemplary embodiments of the present invention and do not represent an entirety of the technical concept of the present invention, it should be understood that a variety of equivalents and modifications capable of substituting the embodiments and the components may be present at the time of filing of the present application.

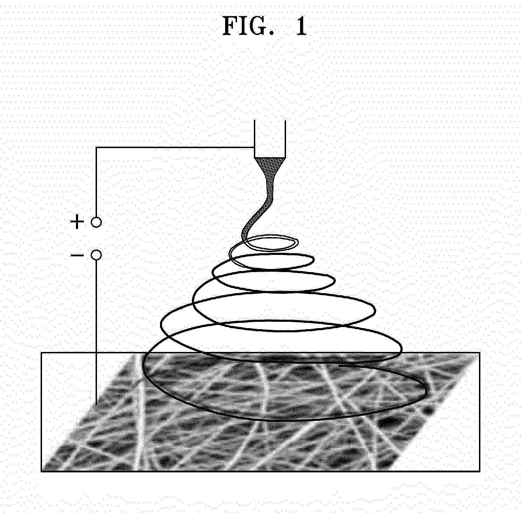

First, a nanostructured material used in a transmission line using a nanostructured material according to the present invention will be described. The nanostructured material refers to a material formed by electrospinning a liquid resin at a high voltage and will be referred to as nanoflon herein. FIG. 1 illustrates an example of an apparatus which manufactures nanoflon through electrospinning. When a polymer solution including polymers is injected into an injector and a high voltage is applied to and the polymer solution flows at a certain speed into between the injector and a substrate on which spinning is performed, as electricity is applied to a liquid suspended from an end of a capillary tube due to surface tension, a nano-sized thread is formed, and as time passes, non-woven nanofibers, which are a nanostructured material, are accumulated. A material formed by accumulating nanofibers as described above is nanoflon. As the polymer material used for electrospinning, for example, there are polyurethane (PU), polyvinylidine diflouride (PVDF), nylon (polyamide), polyacrylonitrile (PAN), and the like. Nanoflon may be used as a dielectric of a transmission line due to low permittivity and a large amount of air.

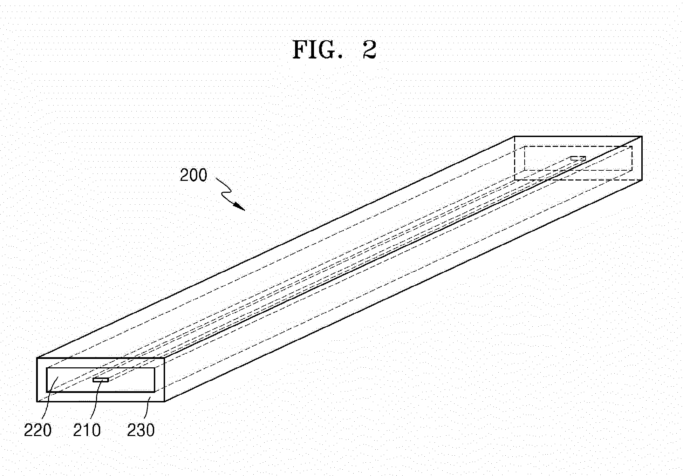

FIG. 2 illustrates an example of a stripline transmission line 200. Referring to FIG. 2, the stripline transmission line 200 may include a signal line 210 which transmits a signal, a dielectric 220 which surrounds the signal line 210, and a conductor 230 which functions as an outer shield.

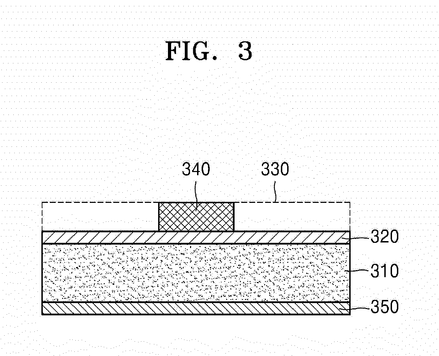

FIG. 3 is a cross-sectional view illustrating a first embodiment of a transmission line manufactured using a transmission line manufacturing method according to the present invention. Referring to FIG. 3, the first embodiment with respect to the transmission line using the nanostructured material according to the present invention includes a first nanoflon layer 310, a first insulating layer 320, a first pattern 340, and a first ground layer 350. The first nanoflon layer 310 includes nanoflon. In the first insulating layer 320, an insulating material is located above the first nanoflon layer 310, and for example, may be located through adhesion. The insulating material is a material capable of preventing an etching solution from being absorbed, and for example, polyimide (PI) which is an organic polymer compound may be used thermally durable plastic.

The first pattern 340 may be formed by etching the first conductive layer 330 formed on the first insulating layer 320 and functions as a transmission line through which a signal is transmitted. Also, the first ground layer 350 may be located below the first nanoflon layer 310, and for example, may be located by adhesion.

The adhesion to the first nanoflon layer 310 may be performed using an adhesive tape, an adhesive, or thermal adhesion in which heat is applied to an adhesive tape.

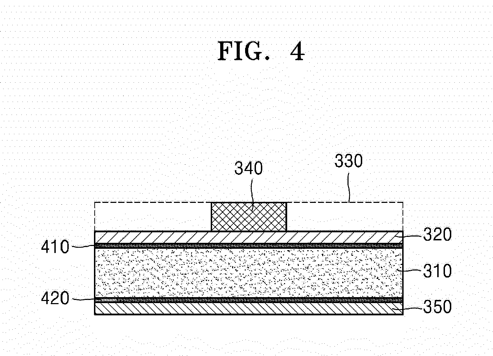

FIG. 4 is a cross-sectional view of the transmission line which illustrates adhesion to the first nanoflon layer 310 according to the transmission line manufacturing method according to the present invention. Reference numeral 410 indicates adhesion between a first nanoflon layer 410 and a first insulating layer 420, and reference numeral 420 indicates adhesion between the first nanoflon layer 310 and the first ground layer 350.

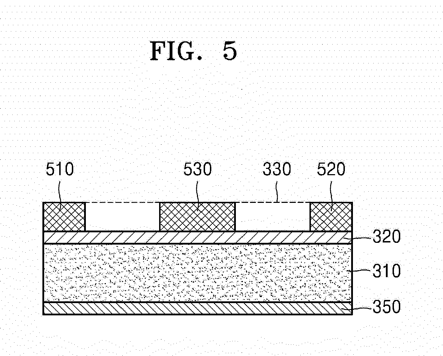

FIG. 5 is a cross-sectional view illustrating a second embodiment of the transmission line manufactured using the transmission line manufacturing method according to the present invention. Referring to FIG. 5, in the second embodiment with respect to the transmission line manufactured according to the present invention, when the first pattern 340 of the first embodiment of the transmission line using the nanostructured material according to the present invention is formed, ground lines 510 and 520 are further formed and the first pattern 340 is used as a signal line. That is, the ground lines 510 and 520 and a signal line 530 are formed by etching the first conductor layer 330.

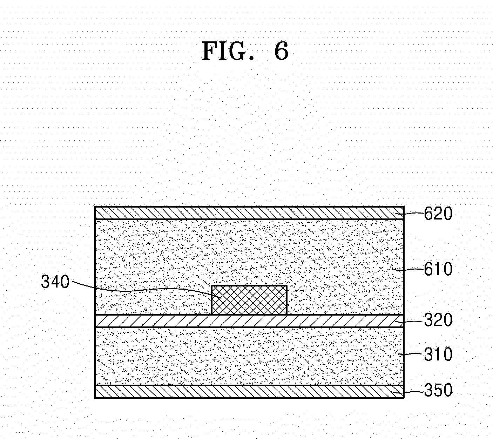

FIG. 6 is a cross-sectional view illustrating a third embodiment of the transmission line manufactured using the transmission line manufacturing method according to the present invention. Referring to FIG. 6, the third embodiment with respect to the transmission line manufactured according to the manufacturing method of the present invention further includes a second nanoflon layer 610 and a second ground layer 620 in addition to the first embodiment (refer to FIG. 3) of the transmission line manufactured using the manufacturing method of the present invention.

The second nanoflon layer 610 may be located above the first pattern 340 formed on the first insulating layer 320 and the first insulating layer 320 exposed by the etching, and may be located through adhesion. The second ground layer 620 may be located above the second nanoflon layer and may be located through adhesion. The adhesion to the second nanoflon layer 610 may be performed using an adhesive tape, an adhesive, or thermal adhesion in which heat is applied to an adhesive tape.

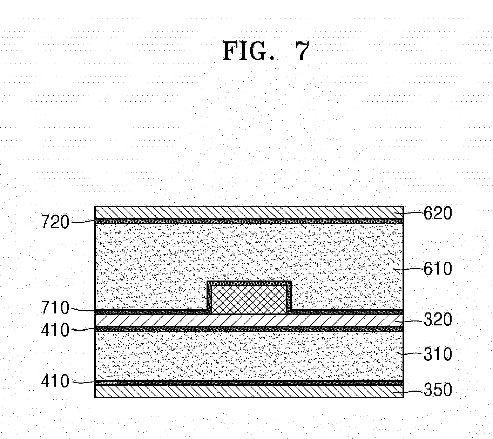

FIG. 7 is a cross-sectional view of the transmission line which illustrates adhesion to the second nanoflon layer 610 according to the transmission line manufacturing method according to the present invention. Reference numeral 710 indicates adhesion between the second nanoflon layer 610 and the first insulating layer 320 and the first pattern 340, and reference numeral 720 indicates adhesion between the second nanoflon layer 610 and the second ground layer 620.

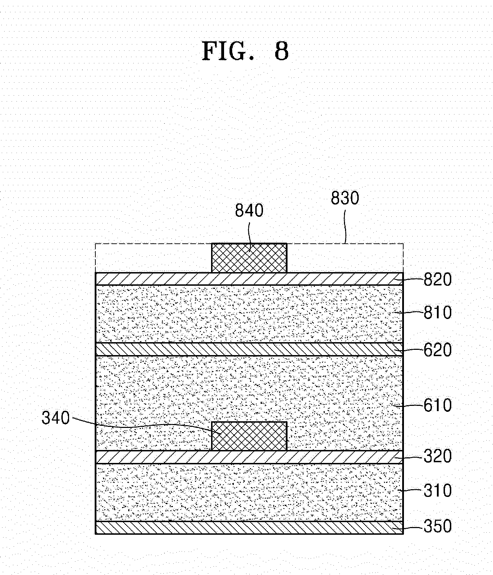

FIG. 8 is a cross-sectional view illustrating a fourth embodiment of a transmission line manufactured using a nanostructured material formed by electrospinning according to a transmission line manufacturing method of the present invention. Referring to FIG. 8, the fourth embodiment with respect to the transmission line using the nanostructured material according to the present invention includes a third nanoflon layer 810, a second insulating layer 820, and a second pattern 840 in addition to the third embodiment (refer to FIG. 6) of the transmission line using the nanostructured material according to the present invention. The third nanoflon layer 810 may be located above the second ground layer 620 and may be located through adhesion. The second insulating layer 820 may be located above the third nanoflon layer 810 and may be located through adhesion. The second pattern 840 may be formed by etching a second conductive layer 830 formed above the second insulating layer 820 and is used as a signal line which transmits a signal. The adhesion to the third nanoflon layer 810 may be performed using an adhesive tape, an adhesive, or thermal adhesion in which heat is applied to an adhesive tape.

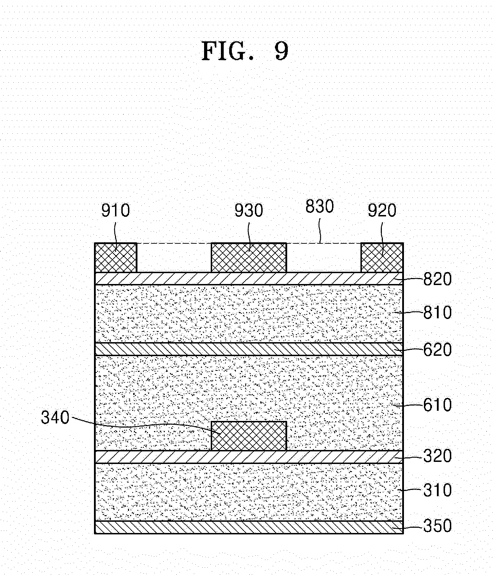

FIG. 9 is a cross-sectional view illustrating a fifth embodiment of the transmission line manufactured using the nanostructured material formed by electrospinning according to the transmission line manufacturing method of the present invention. Referring to FIG. 9, in the fifth embodiment with respect to the transmission line using the nanostructured material according to the present invention, when the fourth embodiment of the transmission line using the nanostructured material according to the present invention is formed, ground lines 910 and 920 are further formed and the second pattern 930 is used as a signal line. That is, the ground lines 910 and 920 and a signal line 930 are formed by etching the first conductor layer 830.

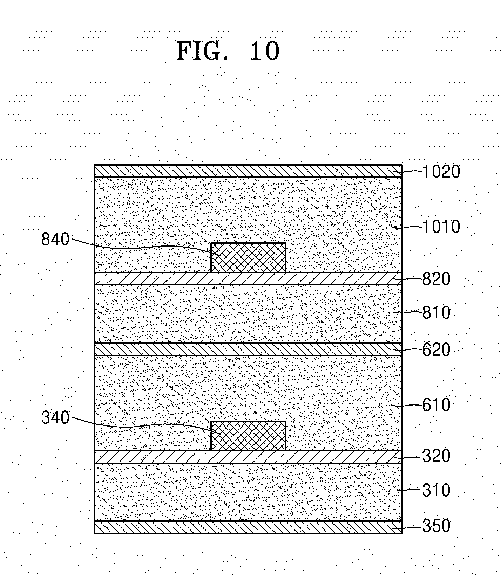

FIG. 10 is a cross-sectional view illustrating a sixth embodiment of the transmission line manufactured using the nanostructured material formed by electrospinning according to the transmission line manufacturing method of the present invention. Referring to FIG. 10, the sixth embodiment with respect to the transmission line using the nanostructured material according to the present invention includes a fourth nanoflon layer 1010 and a third ground layer 1020 in addition to the fourth embodiment (refer to FIG. 8) of the transmission line using the nanostructured material according to the present invention.

The fourth nanoflon layer 1010 may be located above the second pattern 840 formed on the second insulating layer 820 and the second insulating layer 820 exposed by the etching, and may be located through adhesion. The third ground layer 1020 may be located above the fourth nanoflon layer 1010 and may be located through adhesion. The adhesion to the fourth nanoflon layer 1010 may be performed using an adhesive tape, an adhesive, or thermal adhesion in which heat is applied to an adhesive tape.

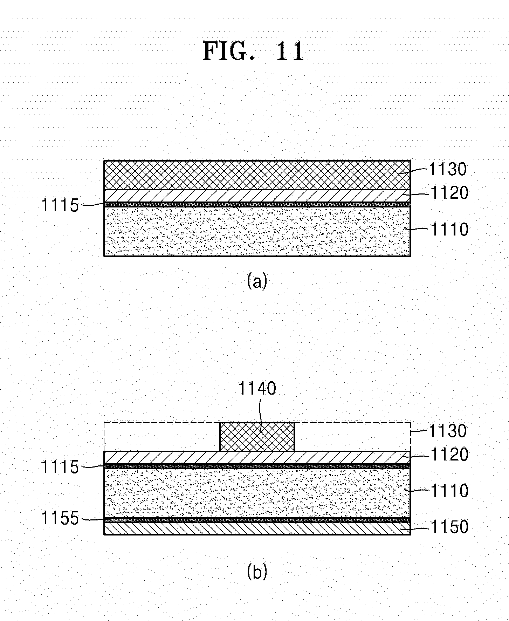

FIG. 11 illustrates a first embodiment of a method of manufacturing a transmission line using a nanostructured material formed by electrospinning according to the present invention. Referring to FIG. 11 (a), a first insulating layer 1120 is located above a first nanoflon layer 1110 formed of nanoflon. For example, the first insulating layer 1120 may be located above the first nanoflon layer 1110 using an adhesive tape or adhesive to the first nanoflon layer 1110 or through thermal adhesion in which heat is applied to an adhesive tape. A first conductive layer 1130 is formed above the first insulating layer 1120.

Referring to FIG. 11 (b), a first pattern 1140, which transmits and receives a signal, is formed by etching the first conductor layer 1130. A first ground layer is located below the first nanoflon layer 1110. For example, a first ground layer 1150 may be located below the first nanoflon layer 1110 using an adhesive tape or an adhesive or through thermal adhesion, in which heat is applied to an adhesive tape, to a bottom of the first nanoflon layer 1110.

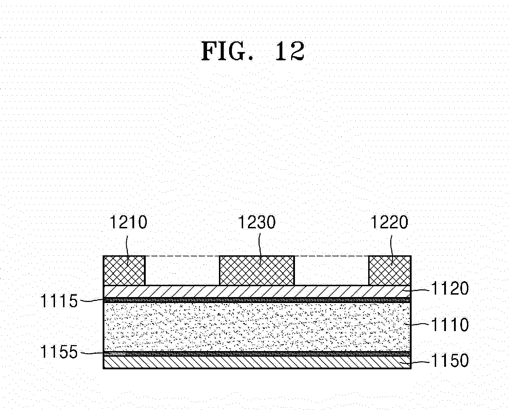

FIG. 12 illustrates a second embodiment of the method of manufacturing the transmission line using the nanostructured material formed by electrospinning according to the present invention. Referring to FIG. 12, in the second embodiment with respect to the method of manufacturing the transmission line using the nanostructured material according to the present invention, when the first embodiment of the method of manufacturing the transmission line using the nanostructured material according to the present invention is formed as shown in FIG. 11 (b), ground lines 1210 and 1220 are further formed and the first pattern 1230 is used as a signal line. That is, the ground lines 1210 and 1220 and a signal line 1230 may be formed by etching the first conductor layer 1130.

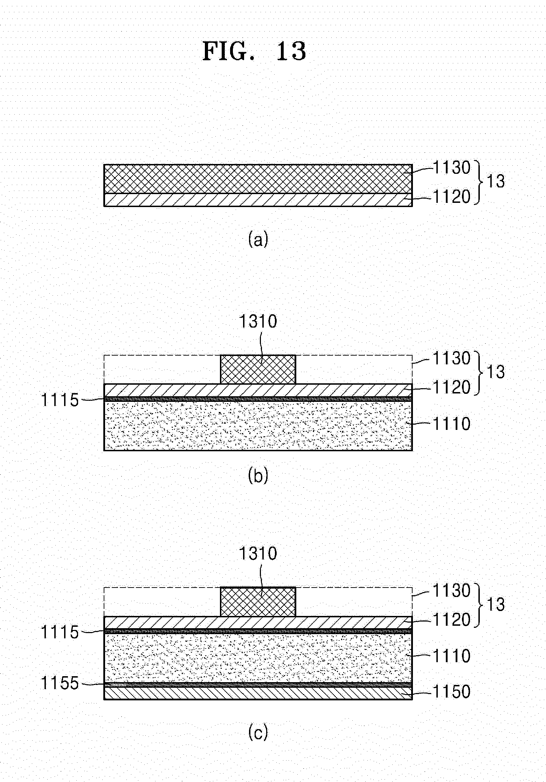

FIG. 13 illustrates a third embodiment of the method of manufacturing the transmission line using the nanostructured material formed by electrospinning according to the present invention. First, an insulating conductive article 13, in which the first conductive layer 1130 is formed above the first insulating layer 1120, is prepared. The insulating conductive article 13 is located above the first nanoflon layer 1110.

A first pattern 1310, which transmits and receives a signal, is formed by locating the insulating conductive article 13 above the first nanoflon layer 1110 and then etching the first conductive layer 1130. The first ground layer 1150 is located below the first nanoflon layer 1110.

The insulating conductive article 13 may be located above the first nanoflon layer 1110 and the first ground layer 1150 may be located below the first nanoflon layer 1110 through adhesion 1115 and 1155, for example, using an adhesive tape or an adhesive or through thermal adhesion, in which heat is applied to an adhesive tape, to the first nanoflon layer 1110.

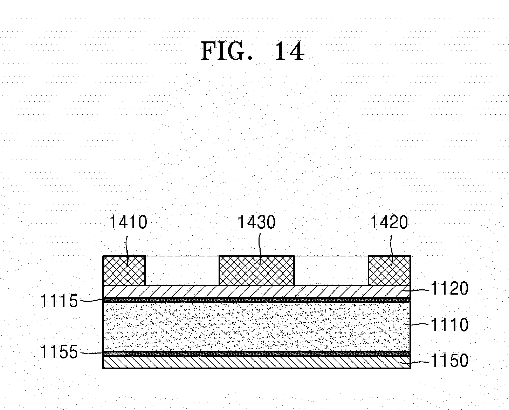

FIG. 14 illustrates a fourth embodiment of the method of manufacturing the transmission line using the nanostructured material formed by electrospinning according to the present invention. Referring to FIG. 14, in the fourth embodiment with respect to the method of manufacturing the transmission line using the nanostructured material according to the present invention, when the third embodiment of the method of manufacturing the transmission line using the nanostructured material according to the present invention is formed as shown in FIG. 13 (c), ground lines 1410 and 1420 are further formed and the first pattern 1430 is used as a signal line. That is, the ground lines 1410 and 1420 and a signal line 1430 may be formed by etching the first conductor layer 1130.

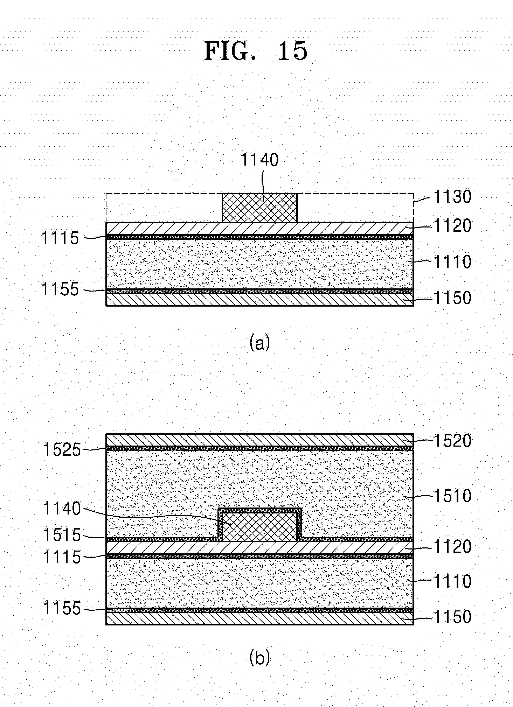

FIG. 15 illustrates a fifth embodiment of the method of manufacturing the transmission line using the nanostructured material formed by electrospinning according to the present invention. FIG. 15 (a) illustrates the first embodiment, shown in FIG. 11 (b), with respect to the method of manufacturing the transmission line using the nanostructured material according to the present invention. As shown in FIG. 15 (b), a second nanoflon layer 1510 is located on a result of the first embodiment of the method of manufacturing the transmission line. For example, the second nanoflon layer 1510 may adhere (1525) to the first pattern 1140 formed on the first insulating layer 1120 and the first insulating layer 1120 exposed by etching in the first embodiment of the method of manufacturing the transmission line. Also, a second ground layer 1520 may be located above the second nanoflon layer 1510. The second ground layer 1520 may be located above the second nanoflon layer 1510 through adhesion 1515. The adhesion 1515 or 1525 may be performed using an adhesive or an adhesive or through thermal adhesion in which heat is applied to an adhesive tape.

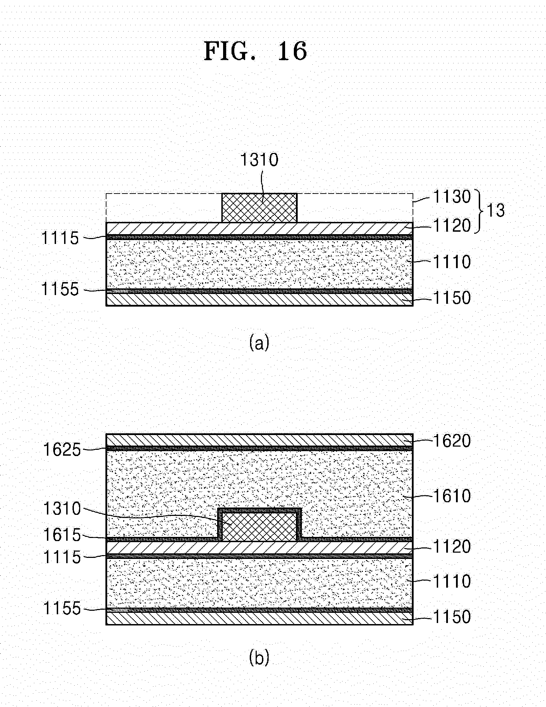

FIG. 16 illustrates a sixth embodiment of the method of manufacturing the transmission line using the nanostructured material formed by electrospinning according to the present invention. Also, FIG. 16 (a) illustrates the third embodiment, shown in FIG. 13 (c), with respect to the method of manufacturing the transmission line using the nanostructured material according to the present invention. As shown in FIG. 16 (b), a second nanoflon layer 1610 is located on a result of the third embodiment of the method of manufacturing the transmission line. For example, the second nanoflon layer 1610 may adhere (1615) to the first pattern 1310 formed on the first insulating layer 1120 and the first insulating layer 1120 exposed by etching in the third embodiment of the method of manufacturing the transmission line. Also, a second ground layer 1620 may be located above the second nanoflon layer 1610. The second ground layer 1620 may be located above the second nanoflon layer 1610 through adhesion 1625. The adhesion 1615 or 1625 may be performed using an adhesive or an adhesive or through thermal adhesion in which heat is applied to an adhesive tape.

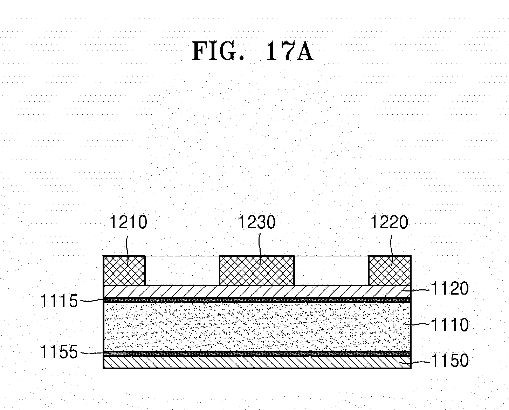

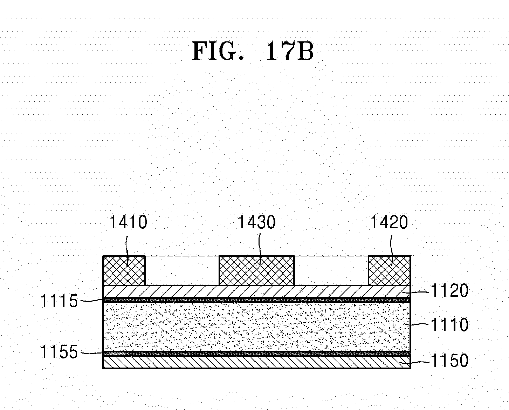

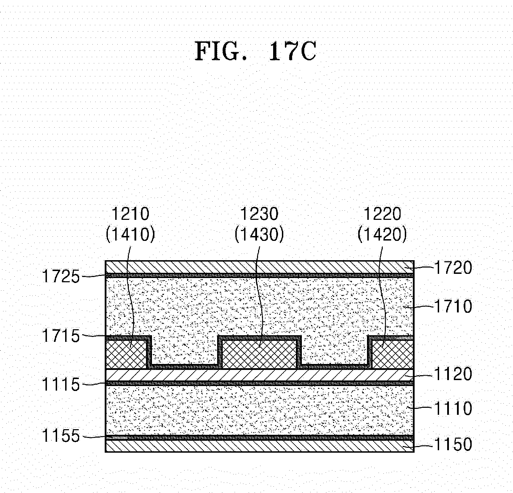

FIGS. 17a, 17b, and 17c illustrate a seventh embodiment of the method of manufacturing the transmission line using the nanostructured material according to the present invention; As shown in FIG. 17c, a second nanoflon layer 1710 is located on a result of the second embodiment of the method of manufacturing the transmission line according to the present invention as shown in FIG. 17a or a result of the fourth embodiment shown in FIG. 17b, and a second ground layer 1720 is located above the second nanoflon layer 1710. The second nanoflon layer 1710 may be located on the ground lines 1210 and 1220 or 1410 and 1420 and the first insulating layer 1120 and the second ground layer 1720 may be located on the second nanoflon layer 1710 through adhesions 1715 and 1725.

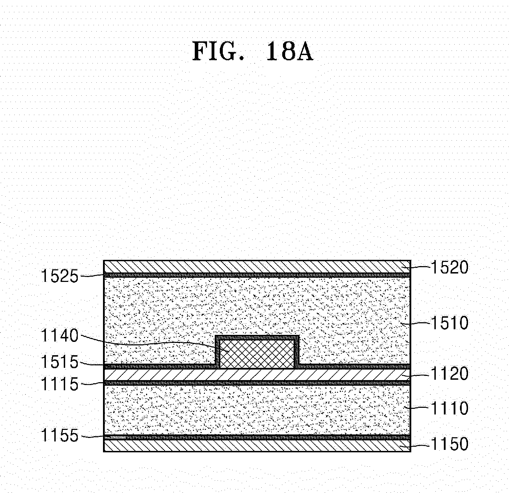

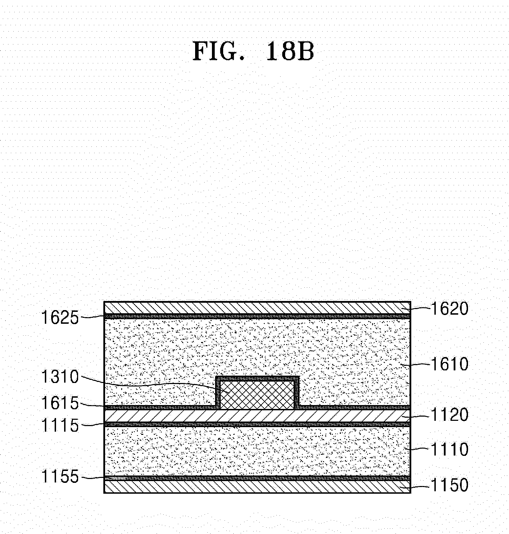

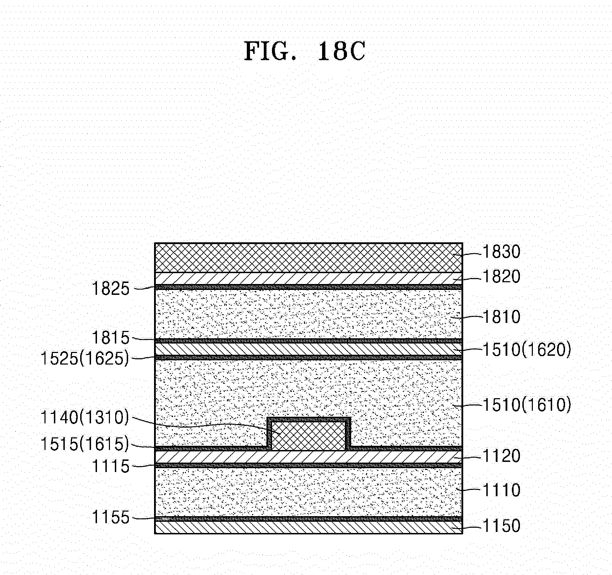

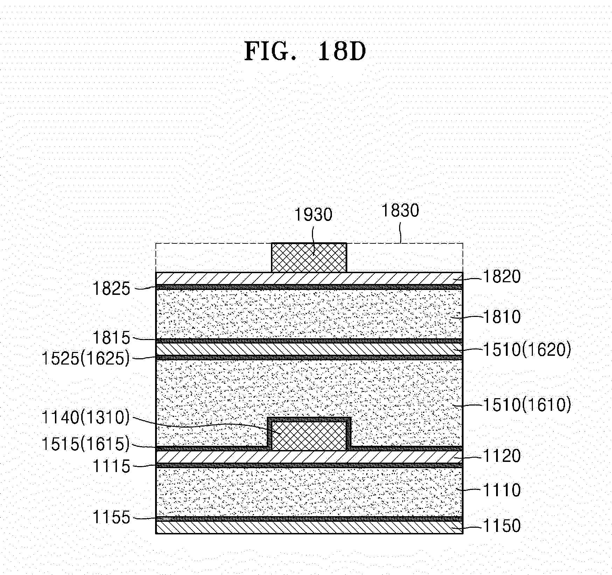

FIGS. 18a, 18b, 18c, and 18d illustrate an eighth embodiment of the method of manufacturing the transmission line using the nanostructured material formed by electrospinning according to the present invention. FIG. 18a illustrates a result of the fifth embodiment of the method of manufacturing the transmission line according to the present invention which is shown in FIG. 15b. FIG. 18b illustrates a result of the sixth embodiment of the method of manufacturing the transmission line according to the present invention which is shown in FIG. 16b. Referring to FIG. 18c, a third nanoflon layer 1810 is located on the result of the fifth embodiment of the method of manufacturing the transmission line according to the present invention as shown in FIG. 18a or the result of the sixth embodiment of the method of manufacturing the transmission line according to the present invention as shown in FIG. 18b and then a second insulating layer 1820 is located above the third nanoflon layer 1810.

Referring to FIG. 18d, a second conductive layer 1830 is formed above the second insulating layer 1820, and then a second pattern 1840, which is a signal line, is formed by etching the second conductive layer 1830. The second ground layers 1520 and 1620 and the second insulating layer 1820 which come into contact with the third nanoflon layer 1810 may adhere (1815 and 1825) to each other using an adhesive tape or an adhesive or through thermal adhesion in which heat is applied to an adhesive tape.

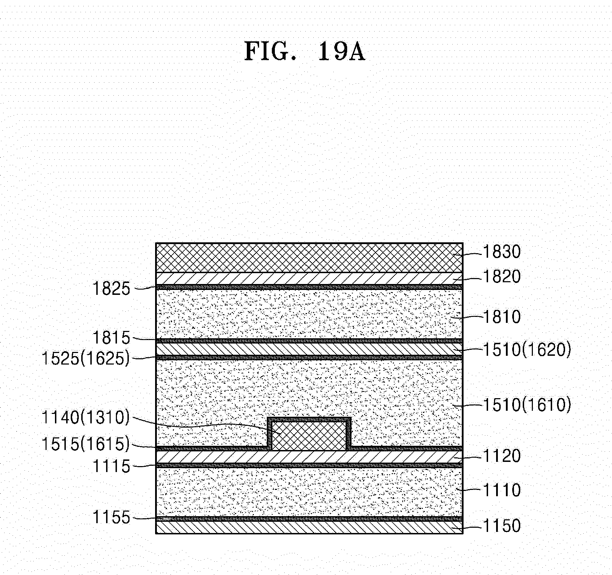

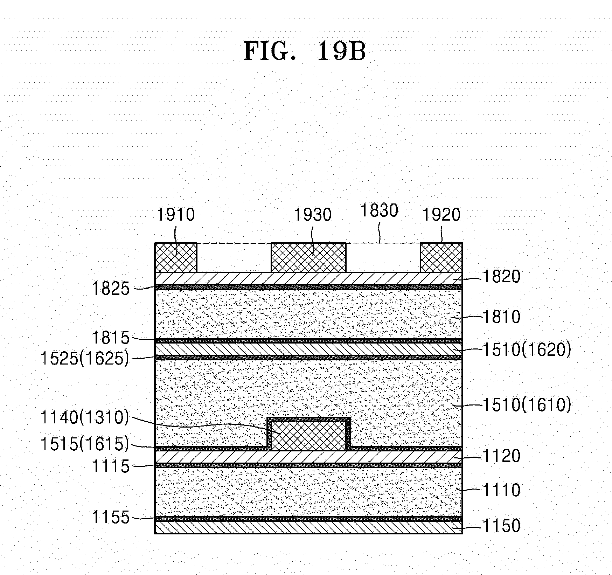

FIGS. 19a and 19b illustrate a ninth embodiment of the method of manufacturing the transmission line using the nanostructured material formed by electrospinning according to the present invention. FIG. 19a relates to FIG. 18c and illustrates forming the second conductive layer 1830 on the second insulating layer 1820 in the eighth embodiment of the method of manufacturing the transmission line according to the present invention. Referring to FIG. 19b, the eighth embodiment of the method of manufacturing the transmission line according to the present invention is formed as shown in FIG. 19a, and then a transmission-signal line 1930 and ground lines 1910 and 1920 are formed by etching the second conductive layer 1830. The second ground layers 1520 and 1620 and the second insulating layer 1820 which come into contact with the third nanoflon layer 1810 may adhere (1815 and 1825) to each other using an adhesive tape or an adhesive or through thermal adhesion in which heat is applied to an adhesive tape.

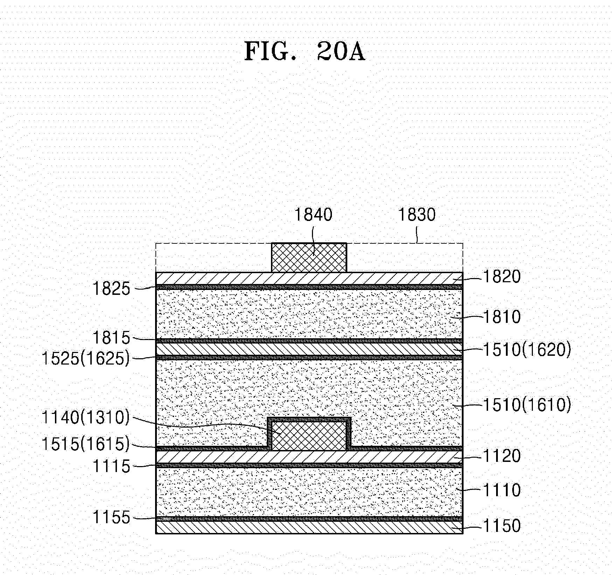

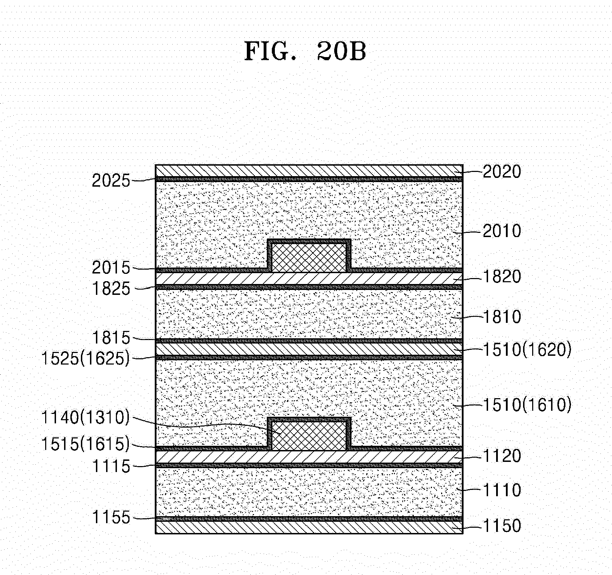

FIGS. 20a and 20b illustrate a tenth embodiment of the method of manufacturing the transmission line using the nanostructured material formed by electrospinning according to the present invention. FIG. 20a relates to FIG. 18d and illustrates a result of the eighth embodiment of the method of manufacturing the transmission line using the nanostructured material according to the present invention.

Referring to FIG. 20b, a fourth nanoflon layer 2010 is located on the second pattern 1840 formed in the eighth embodiment of the method of manufacturing the transmission line and the second insulating layer 1820 exposed by etching, and then a third ground layer 2020 is formed on the fourth nanoflon layer 2010. Here, the fourth nanoflon layer 2010 may be located on the second pattern 1840 and the second insulating layer 1820 exposed by etching through adhesions 2015 and 2025 using an adhesive tape or an adhesive or through thermal adhesion in which heat is applied to an adhesive tape.

According to the embodiments of the present invention, in a method of manufacturing a transmission line using a nanostructured material, a nanostructured material formed by electrospinning a resin at a high voltage is used as a dielectric of a transmission line such that the permittivity of the dielectric, as the transmission line, may be low and a loss tangent value may be reduced at the low permittivity.

Particularly, a transmission line manufactured according to the method of manufacturing the transmission line according to the embodiments of the present invention may be used as a low-loss flat cable for reducing a transmission loss of a high frequency signal in a band from 3.5 GHz and 28 GHz used in a five generation (5G) mobile communication network.

Although the present invention has been described with reference to the embodiments shown in the drawings, it should be understood that the embodiments are merely examples and a variety of modifications and equivalents thereof may be made by one of ordinary skill in the art. Therefore, the technical scope of the present invention should be defined by the technical concept of the attached claims.

## Claims

1. A method of manufacturing a transmission line using a nanostructured material formed through electrospinning, the method comprising:
locating a first insulating layer above a first nanoflon layer including nanoflon;
forming a first conductive layer above the first insulating layer;
forming a first pattern, which transmits and receives a signal, by etching the first conductive layer; and
locating a first ground layer below the first nanoflon layer,
wherein the nanoflon is a nanostructured material formed by electrospinning a liquid resin at a high voltage.

2. A method of manufacturing a transmission line using a nanostructured material formed through electrospinning, the method comprising:
forming a first conductive layer on a first insulating layer;
locating the first insulating layer above a first nanoflon layer including nanoflon;
forming a first pattern, which transmits and receives a signal, by etching the first conductive layer; and
locating a first ground layer below the first nanoflon layer,
wherein the nanoflon is a nanostructured material formed by electrospinning a liquid resin at a high voltage.

3. The method according to any one of claims 1 and 2, wherein the forming of the first pattern comprises forming a ground line and a signal line by etching the first conductive layer.

4. The method according to any one of claims 1 and 2, further comprising:
locating a second nanoflon layer on the first pattern formed on the first insulating layer and the first insulating layer exposed by the etching; and
locating a second ground layer on the second nanoflon layer.

5. The method according to any one of claims 1 and 2, further comprising:
locating a second nanoflon layer on the first pattern formed on the first insulating layer and the first insulating layer exposed by the etching;
locating a second ground layer on the second nanoflon layer;
locating a third nanoflon layer on the second ground layer;
locating a second insulating layer on the third nanoflon layer;
forming a second conductive layer on the second insulating layer; and
forming a second pattern, which transmits and receives a signal, by etching the second conductive layer.

6. The method of claim 5, wherein the forming of the second pattern comprises forming a transmission-signal line and a ground terminal by etching the second conductive layer.

7. The method of claim 5, further comprising:
locating a fourth nanoflon layer on the second pattern formed on the second insulating layer and the second insulating layer exposed by the etching; and
locating a third ground layer on the fourth nanoflon layer.

8. The method according to any one of claims 1, 2, 4, 5, and 7, wherein the locating is performed through adhesion using an adhesive tape or an adhesive or using thermal adhesion in which heat is applied to an adhesive tape.
